# EUROPEAN PATENT SPECIFICATION

(11) **EP 3 401 294 B1**
(45) Date of publication and mention of the grant of the patent: **31.03.2021**
(21) Application number: 18170716.7
(22) Date of filing: 03.05.2018
(51) Int. Cl.: C04B 35/83

(54) **CARBON-CARBON COMPOSITES INCLUDING ENCAPSULATED ISOTROPIC CARBON AND PRODUCTION METHOD THEREOF**
KOHLENSTOFF-KOHLENSTOFF-VERBUNDWERKSTOFFE MIT VERKAPSELTEM ISOTROPEM KOHLENSTOFF UND HERSTELLUNGSVERFAHREN DAFÜR
COMPOSITES CARBONE-CARBONE COMPRENANT DU CARBONE ISOTROPE ENCAPSULÉ ET LEUR PROCÉDÉ DE FABRICATION

(30) Priority: 10.05.2017 US 201715591951
(43) Date of publication of application: 14.11.2018
(73) Proprietor: Honeywell International Inc., Morris Plains, NJ 07950 (US)
(72) Inventor: FRYSKA, Slawomir T., Morris Plains, New Jersey 07950 (US); MURDIE, Neil, Morris Plains, New Jersey 07950 (US); LA FOREST, Mark L., Morris Plains, New Jersey 07950 (US)
(74) Representative: Houghton, Mark Phillip

(56) References cited:
- EP-A1- 2 527 129
- US-A1- 2015 069 646

## Description

### TECHNICAL FIELD

The present disclosure is directed to a carbon-carbon composite materials and techniques for forming carbon-carbon composite materials.

### BACKGROUND

Some carbon-carbon composite bodies, such as some carbon-carbon composite brake discs that are used in the aerospace industry, may be manufactured from porous preforms. The preforms may be densified using one of several processes, such as chemical vapor deposition/chemical vapor infiltration (CVD/CVI), vacuum/pressure infiltration (VPI) or resin transfer molding (RTM) followed by carbonization, which may apply carbon within the porous preform. US2015/069646 discloses a technique of forming a carbon-carbon composite material comprising infusing pyrolysis oil into a porous preform, polymerizing at least some components of the pyrolysis oil infused in the preform to form a phenolic resin, and pyrolyzing the phenolic resin to form a partially densified preform. EP2527129 discloses a liquid carbonizable precursor is infused into a porous preform, and the infused precursor is subsequently pyrolyzed to convert the precursor to a carbon. The carbon enhances rigidity of the preform.

### SUMMARY

The invention is set out in accordance with the appended claims 1-12. A method of forming a carbon-carbon composite component, the method comprising:
depositing an initial carbon material into a porous carbon fiber preform using chemical vapor deposition (CVD) or chemical vapor infiltration (CVI) to form a rigidized porous carbon fiber preform;
infusing the rigidized porous carbon fiber preform with an isotropic resin;
pyrolyzing the infused isotropic resin to form carbon within pores of the rigidized porous carbon fiber preform such that the carbon formed within the pores includes at least 80% isotropic carbon; and
after the infusing and the pyrolyzing, densifying the rigidized porous carbon fiber preform such that the isotropic carbon within the rigidized porous carbon fiber preform is encapsulated with a graphitizable carbon to form the carbon-carbon composite component.

A carbon-carbon composite component comprising:
a rigidized, porous carbon fiber preform comprising a plurality of carbon coated fibers that define a plurality of pores between the carbon coated fibers;
carbon within the plurality of pores and on the carbon coated fibers, wherein the carbon within the plurality of pores includes at least 80% isotropic carbon; and
a graphitizable carbon on the isotropic carbon, wherein the graphitizable carbon encapsulates the isotropic carbon.

The details of one or more examples are set forth in the accompanying drawings and the description below. Other features, objects, and advantages of the disclosure will be apparent from the description and drawings, and from the claims.

### BRIEF DESCRIPTION OF DRAWINGS

FIG. 1 is a flow diagram illustrating an example technique for forming a carbon-carbon composite body from a porous preform.
FIG. 2 is a perspective view of an example porous preform that may be used to form a carbon-carbon composite body.
FIG. 3 is a lateral cross-sectional view of an example porous preform that may be used to form a carbon-carbon composite body.
FIG. 4 is a lateral cross-sectional view of an example rigidized porous preform after subjecting the porous preform of FIG 3 to an initial cycle of CVI/CVD.
FIG. 5 is a lateral cross-sectional view of an example intermediate composite component after infusing an isotropic resin into the porous preform of FIG. 4 and pyrolyzing the isotropic resin to form an isotropic carbon.
FIG. 6 is a lateral cross-sectional view of an example carbon-carbon composite component after encapsulating isotropic resin within the intermediate composite component of FIG. 5 with a graphitizable carbon.

### DETAILED DESCRIPTION

The present disclosure describes carbon-carbon composite materials and techniques for forming carbon-carbon composite materials. The invention is set out in accordance with the appended claims 1-12. Carbon-carbon composite materials are produced from a carbon fiber preform that includes a plurality of carbon fibers or carbon precursor fibers. The carbon fiber preform is subjected to an initial chemical vapor deposition/chemical vapor infiltration (CVD/CVI) to rigidize the carbon fiber preform. Following the initial CVD/CVI cycle, the rigidized carbon fiber preform is infused and pyrolyzed using isotropic resin materials (e.g., phenolic resin or furan resin) to form isotropic carbon within the rigidized carbon fiber preform such that the carbon formed within the pores includes at least 80% isotropic carbon. In some examples, the isotropic carbon formed by the phenolic or furan resin materials may extend substantially throughout a volume of the rigidized carbon fiber preform to increase the amount of carbon material and overall density of the resultant densified preform. The densified preform is then subjected to densification encapsulate the isotropic carbon with a graphitizable carbon (e.g., rough laminar carbon), resulting in a carbon-carbon composite.

The isotropic resin materials used during the intermediate stages provides a relatively inexpensive and efficient means of building up the density and carbon material within the resultant article. For example, in some examples, the isotropic resin materials may include relatively fast thermosetting resin materials that, once cured, remain set within the rigidized carbon fiber preform during the carbonization process (e.g., the isotropic resin materials do not melt or flow from the preform during carbonizations). In some examples, the isotropic resin materials may significantly reduce or eliminate the duration of the stabilization cycle times associated with non-isotropic resins or pitch infiltrant materials. Additionally or alternatively, isotropic resin materials may over a relatively low cost alternative compared to traditional non-isotropic resin or pitch infiltrant materials.

Once carbonized, the isotropic resin materials are converted in to isotropic carbon that adheres to the rigidized carbon fiber preform. In some examples, the isotropic carbon may be relatively hard and fragile. The isotropic carbon provides good structural support for the resultant component, but provides poor frictional characteristics compared to non-isotropic carbon (e.g., carbon produced from non-isotropic resins or pitch infiltrant materials). For example, due to the brittle nature of the isotropic carbon, fictional and sheer forces applied to the resultant component (e.g., during braking) causes the isotropic carbon to fracture, break apart, and become dislodged from the component, ultimately leading to reduce wear properties and service life of the component.

In some examples, by depositing a subsequent layer of graphitizable carbon (e.g., CVI/CVD rough laminar carbon) over the isotropic carbon, the wear performance properties of the resultant component may be significantly improved. The graphitizable carbon encapsulates the isotropic carbon. The graphitizable carbon may help prevent the isotropic carbon from fracturing and becoming dislodged from component. Additionally, the encapsulating graphitizable carbon may exhibit better friction characteristics compared to isotropic carbon resulting in better braking performance. For example, depositing a layer of graphitizable carbon over the isotropic carbon may improve high energy friction performance, such as during rejected take off (RTO) braking, as well as reducing wear rates through the formation of friction films while minimizing variation in friction and wear performance at different stages of brake wear (new and worn brake conditions). Additionally or alternatively, the graphitizable carbons may improve the thermal and structural properties of the carbon composite material.

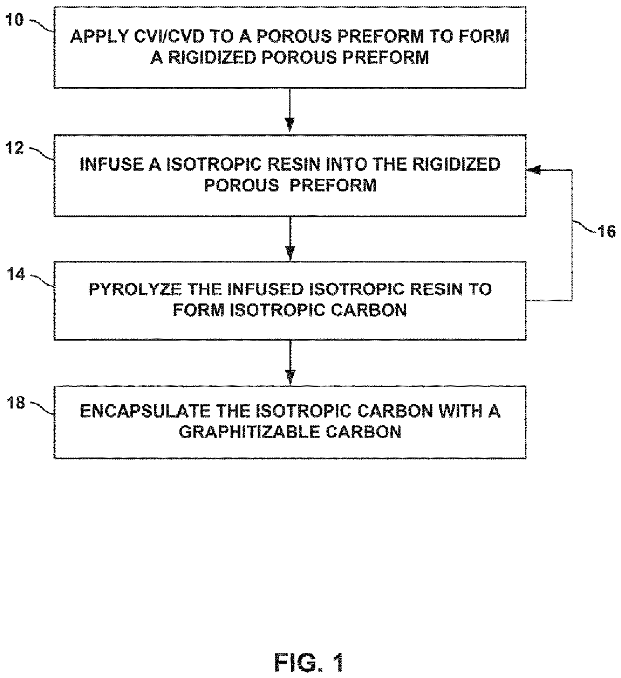

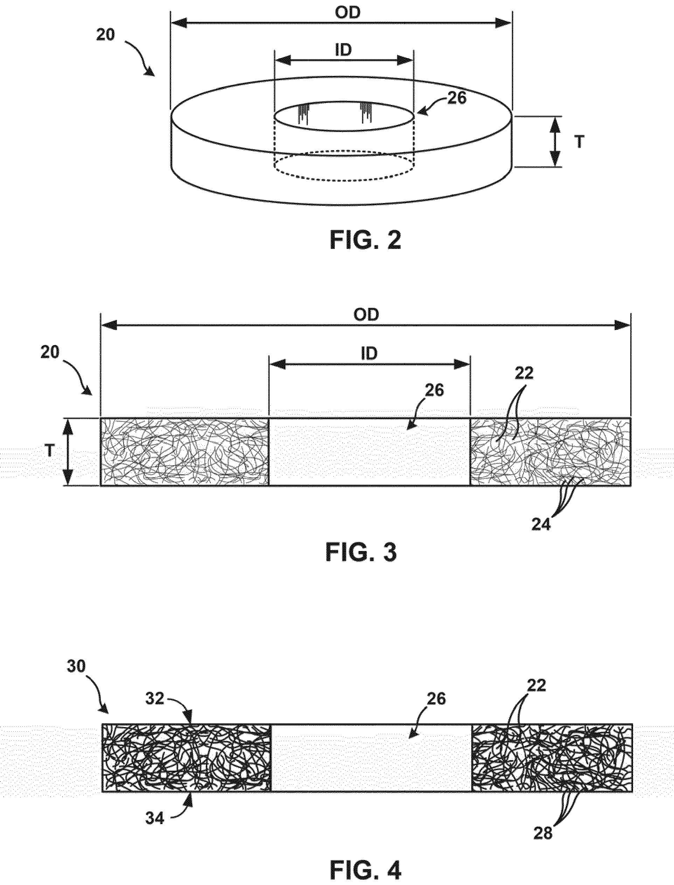

FIG. 1 is a flow diagram illustrating an example technique for forming a carbon-carbon composite body from a porous carbon fiber preform. The technique of FIG. 1 will be described with reference to the conceptual diagrams of FIGS. 2-5, which show different views of an example porous carbon fiber preform at different times during the technique of FIG. 1 and a carbon-carbon composite material resulting from the technique of FIG. 1. The technique of FIG. 1 may be used to form a carbon-carbon composite component 50 that includes a plurality of fibers 24, an isotropic carbon phase 42 that extends substantially throughout a volume of the carbon-carbon composite component 50, and a graphitizable carbon 52 that substantially encapsulates the isotropic carbon 42. Although an example porous preform 20 is depicted in FIGS. 2 and 3, the technique of FIG. 1 may be used with different preforms of other types (e.g., shapes or material compositions) and may be used to form carbon-carbon composites having different shapes or material compositions.

The technique of FIG. 1 includes applying CVI/CVD to a porous preform 20 to form a rigidized porous preform 30 (10). FIGS. 2 and 3 are a perspective view (FIG. 2) and cross-sectional view (FIG. 3) of an example porous preform 20 that may be used in the technique of FIG. 1. The preform is a porous carbon fiber preform. Examples of preforms that may be used as porous preform 20 may include a woven fiber preform, a nonwoven fiber preform, a chopped-fiber and binder preform, a binder-treated random fiber preform; a foam preform; a porous carbon body preform; or a porous ceramic body preforms; and the like. In some examples, porous preform 20 may include, a plurality of fibers 24 that define a plurality of pores 22 within preform 20. In some examples, porous preform 20 may include a plurality of mechanically bound fibrous layers that each include a plurality of fibers 24, such as a plurality of woven or nonwoven fabric layers, connected together using, for example, a needle-punching process to introduce needled fibers through one of more of the fibrous layers to mechanically bond the layers together. In some examples, the fibrous layers may include tows of fibers 24, each tow including a plurality of fiber filaments. In other examples, porous preform 20 may not include predefined layers, but, rather, can be formed from a bundle of fibers 24 that are mechanically bound together, e.g., via needling. In other examples, a combination of any of the aforementioned types of preforms may be used.

The porous preform includes carbon fibers. In some examples the fibers may include carbon precursor fibers such as polyacrylonitrile (PAN) fibers, oxidized polyacrylonitrile (O-PAN) fibers, rayon fibers, or the like, which may be subsequently pyrolyzed to form carbon fibers prior to the initial CVI/CVD processing cycle (10). As used herein, the term "carbon fibers" is used to describe both preforms that include carbon fibers or carbon precursor fibers that have been subsequently converted to carbon fibers.

In some examples, porous preform 20 may be in the form of a disc, e.g., for use as a brake disc, that includes central aperture 26 extending through an axial thickness of the preform and defined by inner diameter (ID) and an outer diameter (OD). In other examples, porous preform 20 may define a different geometry. For example, the geometry of porous preform 20 may be similar to or substantially the same as the desired geometry for the finished part formed by the carbon-carbon composite component 50. Porous preform 20 may also define an axial thickness T measured in a direction substantially orthogonal to the direction in which inner diameter ID and outer diameter OD are measured. In some examples, the porosity of porous preform 20 may extend substantially throughout the thickness T of porous preform 20. Fibers 24 and pores 22 are not necessarily shown to scale in FIG. 3, but rather are shown conceptually in order to illustrate aspects of the present disclosure. As described above, fibers 24 may be provided in the form of one or more layers (e.g., woven tow layers, non-woven layers, or combinations thereof) that are bound together (e.g., needled fibers and/or binder material) wherein pores 22 represent the spacing in between adjacent filaments of fibers 24.

During the initial CVI/CVD deposition process (10), an initial deposit of carbon is applied within pores 22 of porous preform 20 to at least partially coat fibers 24 with carbon (e.g. carbon coated fibers 28) and increase the rigidity of the preform resulting in rigidized porous preform 30. FIG. 4 is a conceptual diagram illustrating a lateral cross-sectional view of an example of rigidized porous preform 30 following the initial CVI/CVD processing cycle applied porous preform 20. In some examples, the initial deposition of carbon material via the CVI/CVD deposition process may help to further bind fibers 24 and/or layers of fibers 24 together to help prevent damage to fibers 24 during subsequent processing steps. For example, absent the initial CVI/CVD deposition process steps, the fibers 24 within porous preform 20 may undergo separation or delamination during the subsequent resin infiltration techniques due to the pressure differential created within porous preform 20 as the resin material is forced into the interior pores 22 of porous preform 20. The initial CVI/CVD application (10) may help strengthen and bind fibers 24 (e.g., resultant coated fibers 28) together thus reducing the chance of separation or delamination during the subsequent resin infiltration steps. Additionally or alternatively, the initial coating of carbon material on fibers 24 generated by the CVI/CVD deposition process (10) may be designed to have rough laminar microstructure, which after high temperature heat treatment (1400 C to 2600 C) may produce a graphitic or partially graphitic crystalline structure that tends to improve friction and wear performance.

In some examples, the initial CVI/CVD deposition process (10) may be carried out using a carbonaceous gas to deposit the initial carbon on and around fibers 24. Any suitable carbonaceous gas may be used during the CVI/CVD processing including, for example, carbon-based gases such as natural gas, methane, ethane, propane, butane, propylene, or acetylene, or a combination of at least two of these gases. In some examples, the initial carbon material may be deposited in porous preform 20 by applying one or more cycles of the CVI/CVD. In some examples, the application of the carbonaceous gas to porous preform 20 via the initial CVI/CVD deposition process (10) may occur substantially in a vacuum space (e.g., a vessel with an internal environment at less than 100 Torr (e.g., 133.3 kPa)) or under an inert gas environment so as to control the chemical deposition reaction. In some examples, during application of the CVI/CVD gas, the environment including porous preform 20 may be heated to an elevated temperature, for example between about 900 °C and about 1200 °C, to promote the chemical deposition reaction of the initial carbon material to form carbon coated fibers 28.

In some examples, the density of rigidized porous preform 30 may be between to about 0.8 g/cm³ and about 1.7 g/cm³ prior to proceeding to infusing of rigidized porous preform 30 with isotropic resin (12).

The technique of FIG. 1 also includes infusing an isotropic resin into rigidized porous preform 30 (12) and pyrolyzing the infused isotropic rein to form isotropic carbon (14). The isotropic carbon produced by the pyrolyzed isotropic resin may at least partially encapsulate carbon coated fibers 28. In some examples, the isotropic resin may be infused substantially throughout (e.g., throughout or nearly throughout) the thickness of rigidized porous preform 30. Additionally or alternatively, the infused isotropic resin may be infused to a predetermined depth within porous preform 20. As used herein, "predetermined depth" may refer to an absolute or relative depth from outer edges of preform body 22, such as from outer edges defined by the inner or outer diameters or from the upper or lower friction surfaces (e.g., first and second major surface 32 and 34 of FIG. 3) of rigidized porous preform 30.

The isotropic resin may include a carbon precursor that, once pyrolyzed, forms an isotropic carbon 42. In some examples, the term "isotropic resin" may be used to characterize a resin that, under standard free-state pyrolysis conditions independent of the preform (e.g., pyrolyzing the isotropic resin independent of the preform so that the preform architecture, pore size distributions, density, and the like does not influence the pyrolyzation process), forms carbon that substantially includes an isotropic phase (e.g., more than about 90% of the carbon formed by pyrolyzing the isotropic resin under standard free-state pyrolysis conditions is isotropic carbon). In some examples, the carbon generated by the pyrolysis of the isotropic resin under standard free-state pyrolysis conditions may include more than about 95% isotropic carbon, and in some examples more than about 98% isotropic carbon. The degree of isotropic carbon 42 formed within the rigidized porous preform 30 may depend on a variety of factors including, for example, the initial density of rigidized porous preform 30. For example, the lower the initial density of rigidized porous preform 30 (e.g., 0.8 g/cc density) the more isotropic carbon 42 will be produced from pyrolyzing the isotropic resin. In some examples, the carbon material produced by pyrolyzing the isotropic carbon within the rigidized porous preform 30 may include majority isotropic carbon. The carbon material produced by pyrolyzing the isotropic carbon within the rigidized porous preform 30 includes at least 80% isotropic carbon.

Suitable isotropic resins may include, for example, a phenolic resin such as resol; a polymerizable aldehyde such as novolac; a furan resin such as furfuryl alcohol, furfuryl alcohol anhydride, or furfural-acetone that can be polymerized to from a furan resin (e.g., poly(furfuryl alcohol)); or combinations thereof. In some examples, the isotropic resin infiltrated into rigidized porous preform 30 may consist essentially of isotropic resin.

In some examples, the isotropic resin may include a thermoset resin that once infused into porous preform 30, sets to form an insoluble polymer that will not melt or leech out of porous preform 30 during the pyrolysis process (14). In some examples, an isotropic resin in the form of a thermoset resin (e.g., furfuryl alcohol) may substantially reduce the processing times and costs associated with densifying porous preform 30. For example, traditional pitch materials (e.g., mesophase or coal tar pitch) used during the densification processes require extended stabilization cycles on the order of several days at elevated temperatures to allow the pitch materials to crosslink and network within a porous preform structure (e.g., rigidized porous preform 30). Absent such extended stabilization cycles, the temperature increase during the pyrolysis cycle may cause a some of the pitch materials to soften and flow/leech from the porous preform structure before the pitch is converted to carbon. This leeching effect can be wasteful, costly, and highly inefficient. Additionally the leeching effect may lead to density non-uniformity within the resultant composite structure, reduced density values, or both. By using, the isotropic resin to build up the density of rigidized porous preform 30, the efficiency and cost associated with densifying the rigidized porous preform 30 may be significantly improved.

In some examples, the isotropic resin may define a relatively low viscosity (e.g., compared to non-isotropic resins or pitch materials) so that the isotropic resin may be infused substantially throughout the entire volume of rigidized porous preform 30. In some examples, the isotropic resin may be relatively non-viscous. In one example, the viscosity of the isotropic resin may be between about 4 centipoise (cp) and 200 cp at the infusion temperature (e.g., the temperature in which the isotropic resin is infiltrated into rigidized porous preform 30, which may be a target temperature between about 25 °C and about 180 °C). For example, furfuryl alcohol has a viscosity of about 4.6 cp (e.g., 4.6 mPa) at 25 °C.

The isotropic resin may be infused into rigidized porous preform 30 using any suitable technique including, for example, a resin transfer mold (RTM) or vacuum pressure infiltration (VPI). For example, VPI may include immersing rigidized porous preform 30 in the isotropic resin and subjecting rigidized porous preform 30 and the isotropic resin to a vacuum, such that the resin is drawn into rigidized porous preform 30. In some examples, the VPI may be performed at room temperature (e.g., about 25 °C) or may be performed at elevated infusion temperature (e.g., about 40 °C or up to 180 °C depending on the resin) to aid infusion of the isotropic resin into pores 22 of rigidized porous preform 30.

In examples where an RTM is used, rigidized porous preform 30 may be placed into a mold matching the desired part geometry. The isotropic resin may be injected at low temperature (50 °C to 150 °C) using pressure or induced under vacuum, into rigidized porous preform 30 contained within a mold. The isotropic resin is cured within the mold before being removed from the mold. In some examples, the isotropic resin may be rapidly injected into mold 40, e.g., within between about 10 seconds and about 40 seconds, such as about between about 15 seconds and about 40 seconds, using an injection apparatus.

In some examples, the isotropic carbon 42 may be formed using furfuryl alcohol as the isotropic resin. In such examples, the furfuryl alcohol may be infused into rigidized porous preform 30 using a VPI or RTM process. The furfuryl alcohol has low viscosities which makes the alcohol easy to process and infiltrate into rigidized porous preform 30. Further the furfuryl alcohol is comparatively less prone to blocking or otherwise occluding the pores of rigidized porous preform 30 upon conversion into isotropic carbon 42 thereby allowing for subsequent infiltration by the graphitizable carbon material as described further below. The infiltration of the rigidized preform with a furan resin (e.g., furfuryl alcohol or furfuryl acetone) may be performed under vacuum and/or pressure. The rigidized porous preform 30 containing the furan resin may be polymerized using an acid bath (e.g., sulfuric acid, phosphoric acid, or the like) followed by placing the infiltrated rigidized porous preform 30 in another bath to neutralize the excess acid and rinsed with de-ionized water. Rigidized porous preform 30 may then be subsequently processed to pyrolyze the polymerized furan resin.

After infusing the isotropic resin into rigidized porous preform 30 (12), the technique of FIG. 1 includes pyrolyzing the isotropic resin to form isotropic carbon (14). In some examples, the isotropic resin may be pyrolyzed by heating the infused rigidized preform 30 up to at least the charring temperature of the isotropic resin (e.g., greater than 650 °C). In some examples, the temperature at which the isotropic resin is pyrolyzed may affect whether the deposited isotropic carbon 42 is porous or nonporous (e.g., exhibits a porosity within isotropic carbon 42 as opposed to the non-occluded pores 22). For example, pyrolyzing the isotropic resin at a higher temperature may lead to cracking of the isotropic carbon 42 during the pyrolysis procedure, resulting in porous isotropic carbon. In some examples, the infused rigidized preform 30 may be heated to a temperature of between about 650 °C (about 1200 °F) and about 910 °C (about 1670 °F) to pyrolyze the isotropic resin and form a substantially nonporous morphology. In other examples, the infused rigidized preform 30 may be heated to temperatures between about 1600 °C (about 2900 °F) and about 2700 °C (about 4890 °F) to pyrolyze the isotropic resin and form a porous morphology. In some examples, the infused rigidized porous preform 30 may be subjected to a relatively small pressure during the pyrolysis process (14), for example between about 110 kilopascals (about 16 pounds per square inch (PSI)) and about 350 kilopascals (about 50 PSI). However pressurization may not be necessary in other examples.

Additionally or alternatively, the isotropic resin may be infused (12) and pyrolyzed (14) at lower temperatures to produce isotropic carbon 42. The process steps (12) and (14) may be repeated (16) one or more times to create a buildup of isotropic carbon 42. The resultant intermediate composite structure 40 may then be subsequently heat treated (e.g., heated to a temperature greater between about 1600 °C (about 2900 °F) and about 2700 °C (about 4890 °F)) to develop porosity within isotropic carbon 42.

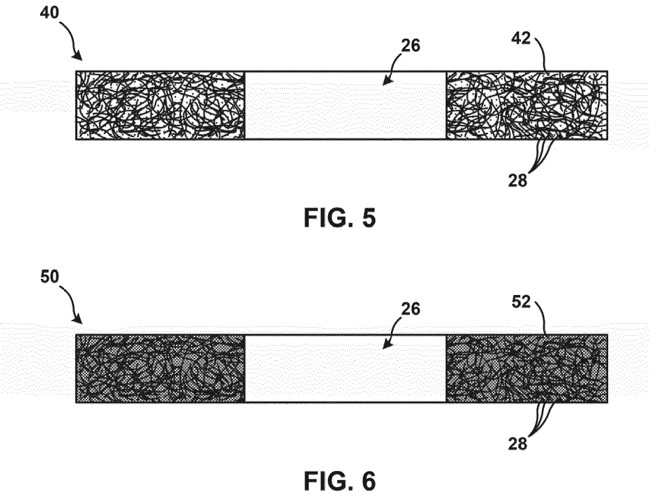

The isotropic carbon may be used to increase the carbon content, density, and strength of rigidized porous preform 30. Additionally or alternatively, the isotropic carbon may further enhance the rigidity and/or the stability of rigidized porous preform 30. FIG. 5 shows the same cross-sectional view as in FIG. 4, but after the isotropic resin has been infused into rigidized porous preform 30 (12) and pyrolyzed to form isotropic carbon 42 within intermediate composite component 40 (14). In some examples, the infusion and pyrolyzation of the isotropic resin (e.g., steps (12) and (14)) may be repeated (16) one or more times to increase the carbon content an density of intermediate composite component 40. In some examples, the isotropic carbon 42 may at least partially fill the pores 22 within rigidized porous preform 30. In some examples, intermediate composite component 40 may remain slightly porous (e.g., have an open porosity of less than about 20% by volume) to facilitate the subsequent infiltration of graphitizable carbon 52. Isotropic carbon 42 may at least partially encapsulate carbon coated fibers 28. In some examples, isotropic carbon 42 may substantially surround or encapsulate a majority of carbon coated fibers 28.

The resultant density of intermediate composite component 40 may be dependent on a variety of factors including, for example, the initial density of rigidized porous preform 30, the initial porosity of rigidized porous preform 30, the number of isotropic resin infusion cycles applied to rigidized porous preform 30, and the like. In some examples, the density of intermediate composite component 40 may be increased to about 1.3 g/cm³ and about 1.85 g/cm³ (e.g., between about 1.7 g/cm³ to about 1.85 g/cm³) prior to proceeding to encapsulating isotropic carbon 42 with a graphitizable carbon 52 (18).

After the completion of one or more cycles (16) of infusing rigidized porous preform 30 with an isotropic resin (14) and pyrolyzing the isotropic resin to produce an isotropic carbon (14), isotropic carbon 42 may be encapsulated with a graphitizable carbon 52 to form a carbon-carbon composite component 50, as shown in FIG. 6. FIG. 6 is a lateral cross-sectional view of a portion of an example carbon-carbon composite component 50 that includes a plurality of carbon fibers coated in an initial carbon material (e.g., carbon coated fibers 28) via an initial CVI/CVD deposition process (12), followed by a buildup of isotropic carbon 42 deposited on and around carbon coated fibers 28 followed by an encapsulation of the isotropic carbon 42 with a graphitizable carbon 52. As used herein "graphitizable carbon" is used to describe a deposited carbon (for example rough laminar carbon) that has a highly ordered, anisotropic structure that becomes graphitic on heat treatment to temperatures greater than about 1800 °C. A "non-graphitizable" carbon is used to describe a deposited carbon (for example smooth isotropic carbon) that has a disordered, isotropic structure that is non-graphitic on heat treatment to temperatures greater than about 1800 °C. In some examples, graphitizable carbon 52 may include at least some graphitic carbon produced by a CVI/CVD deposition process, a RTM/VPI pyrolysis process, a heat treatment process, or a combination thereof.

In some examples, by encapsulating isotropic carbon 42 with graphitizable carbon 52 may substantially improve the frictional performance and mechanical durability of carbon-carbon composite component 50 compared to a component with a non-encapsulated isotropic carbon. For example, isotropic carbon 42 on its own may be hard yet relatively fragile. During braking operations of a carbon-carbon composite component that includes isotropic carbon 42 as an outer layer (e.g., use of intermediate composite component 40 absent a subsequent application of graphitizable carbon) may cause the fragile isotropic carbon 42 to fracture and break apart under the sheer and frictional loads applied to the carbon composite component. The fracturing of the isotropic carbon 42 may cause chunks isotropic carbon 42 to become dislodged from the carbon composite component leading to reduced frictional power of the component and reduced durability and service life of the resultant component.

By encapsulating isotropic carbon 42 with an exterior application of graphitizable carbon 52, the otherwise poor frictional and mechanical aspects of isotropic carbon 42 may be significantly reduced or prevented. For example, without wanting to be bound to a specific scientific theory, it is believed that the graphitizable carbon 52 has better fracture resistance compared to isotropic carbon 42. By at least partially encapsulating the isotropic carbon 42 with graphitizable carbon 52, the graphitizable carbon 52 performs as a binder to help prevent the fracturing of isotropic carbon 42 and its general dislodgement from the final carbon-carbon composite component 50. Additionally, graphitizable carbon 52 exhibits a higher coefficient of friction but may exhibit a reduced strength (e.g., hardness) compared to isotropic carbon 42. Thus, carbon-carbon composite component 50 may exhibit improved braking strength and coefficient of friction compared to a component including either graphitizable carbon 52 or isotropic carbon 42 independently.

Graphitizable carbon 52 may be applied to isotropic carbon 42 using any suitable technique. For example, in some examples, graphitizable carbon 52 may be produced by infusing and pyrolyzing intermediate composite component 40 with an anisotropic pitch material using one or more cycles of RTM/VPI using similar techniques to those described above. Example anisotropic pitch materials suitable for generating graphitizable carbon 52 may include, for example, synthetic mesophase pitches, coal-tar derived pitches, such as thermally or chemically treated coal tar, petroleum-derived pitches, synthetic-pitch derivatives, thermally treated pitches.

Additionally or alternatively, the graphitizable carbon 52 may be produced using one or more cycles of CVI/CVD. Depending on the processing parameters including for example, the deposition temperature, selection/composition of carbonaceous gas, carbonaceous gas flow rate, type of deposition equipment, duration of the application, and the like, a CVI/CVD deposition process may be configured to produce semi-isotropic carbon, smooth laminar carbon, or rough laminar carbon. The CVI/CVD deposition process may be configured to produce a rough laminar carbon microstructure. In some examples, the resultant deposit of graphitizable carbon 52 may be characterized as having a rough laminar carbon microstructure that includes a non-isotropic carbon material and defines about a 16 degree to about a 24 degree extinction angle as measured by optical microscopy using polarized light.

Example carbonaceous gas materials that are more prone to forming rough laminar carbon may include, for example, propane. In some examples, the formation of the rough laminar carbon using the CVI/CVD deposition process may be increased by using higher process temperatures. In some examples, graphitizable carbon 52 exhibiting a rough laminar carbon microstructure may be produced by conducting the CVI/CVD process at temperature of about 1025 °C with at least 6% of propane by volume added to natural gas.

In some examples, encapsulating isotropic carbon 42 with graphitizable carbon 52 using one or more CVI/CVD deposition process may provide a more uniform application of graphitizable carbon 52 over isotropic carbon 42 compared to a RTM/VPI process. In some examples, graphitizable carbon 52 may be produced using a combination of one or more CVI/CVD and RTM/VPI cycles.

In some examples, graphitizable carbon 52 may form the final (e.g., exterior) coating of carbon material on carbon-carbon composite component 50 such that no additional carbon material is applied to carbon-carbon composite component 50 upon the completion of encapsulating isotropic carbon 42 with graphitizable carbon 52 (18). In some examples, the completed carbon-carbon composite component 50 may define a final density between about 1.7 g/cm³ and about 1.9 g/cm³ (e.g., between about 1.72 g/cm³ to about 1.87 g/cm³).

In some examples, carbon-carbon composite component 50 may be shaped (e.g., mechanically machined) into a brake disc after encapsulating isotropic carbon 42 with graphitizable carbon 52 (18). In some examples, following the encapsulation of the isotropic carbon 42 with graphitizable carbon 52, carbon-carbon composite component 50 may go through a final heat treatment process (e.g., heat treated at temperatures greater than about 1800 °C) to increase the degree of graphitic carbon within graphitizable carbon 52, and are then machined to final dimensions. Additionally or alternatively, carbon-carbon composite component 50 may be coated with an anti-oxidant protection system.

Various examples have been described. These and other examples are within the scope of the following claims.

## Claims

1. A method of forming a carbon-carbon composite component, the method comprising:
depositing an initial carbon material into a porous carbon fiber preform using chemical vapor deposition (CVD) or chemical vapor infiltration (CVI) to form a rigidized porous carbon fiber preform;
infusing the rigidized porous carbon fiber preform with an isotropic resin;
pyrolyzing the infused isotropic resin to form carbon within pores of the rigidized porous carbon fiber preform such that the carbon formed within the pores includes at least 80% isotropic carbon; and
after the infusing and the pyrolyzing, densifying the rigidized porous carbon fiber preform such that the isotropic carbon within the rigidized porous carbon fiber preform is encapsulated with a graphitizable carbon to form the carbon-carbon composite component.

2. The method of claim 1, wherein the isotropic resin comprises phenolic resin or furan resin.

3. The method of claim 1 or 2, wherein densifying the rigidized porous preform such that the isotropic carbon within the rigidized porous preform is encapsulated with the graphitizable carbon comprises:
applying at least one CVI/CVD cycle to the rigidized porous preform including the isotropic carbon to encapsulate the isotropic carbon with the graphitizable carbon.

4. The method of any of claims 1 to 3, wherein graphitizable carbon comprises rough laminar carbon.

5. The method of any of claims 1 to 4, wherein the graphitizable carbon forms the outermost layer of carbon material in the carbon-carbon composite component.

6. The method of any of claims 1 to 5, further comprising heat treating the isotropic carbon prior to encapsulating the isotropic carbon with the graphitizable carbon.

7. The method of any of claims 1 to 6, wherein a density of the rigidized porous preform prior to infusion of the isotropic resin is between 0.8 g/cm³ and 1.7 g/cm³.

8. The method of any of claims 1 to 6, wherein a density of the carbon-carbon composite component is between 1.72 g/cm³ and 1.87 g/cm³.

9. The method of any of claims 1 to 6, wherein the density of the infused and pyrolized preform is between 1.3 g/cm³ and 1.85 g/cm³.

10. A carbon-carbon composite component comprising:
a rigidized, porous carbon fiber preform comprising a plurality of carbon coated fibers that define a plurality of pores between the carbon coated fibers;
carbon within the plurality of pores and on the carbon coated fibers, wherein the carbon within the plurality of pores includes at least 80% isotropic carbon; and
a graphitizable carbon on the isotropic carbon, wherein the graphitizable carbon encapsulates the isotropic carbon.

11. The carbon-carbon composite component of claim 10, wherein graphitizable carbon comprises rough laminar carbon.

12. The carbon-carbon composite component of any of claims 10 or 11, wherein a density of the carbon-carbon composite component is between 1.72 g/cm³ and 1.87 g/cm³.

## Patentansprüche

1. Verfahren zum Bilden einer Kohlenstoff-Kohlenstoff-Verbundwerkstoffkomponente, wobei das Verfahren umfasst:
Abscheiden eines Kohlenstoff-Ausgangsmaterials in einem porösen Kohlenstofffaservorformling unter Verwendung chemischer Dampfabscheidung (CVD, chemical vapor deposition) oder chemischer Dampfphaseninfiltration (CVI, chemical vapor infiltration), um einen versteiften porösen Kohlenstofffaservorformling zu bilden;
Infundieren des versteiften porösen Kohlenstofffaservorformlings mit einem isotropen Harz;
Pyrolysieren des infundierten isotropen Harzes, um Kohlenstoff innerhalb von Poren des versteiften porösen Kohlenstofffaservorformlings zu bilden, sodass der innerhalb der Poren gebildete Kohlenstoff mindestens 80 % isotropen Kohlenstoff einschließt; und
nach dem Infundieren und Pyrolysieren Verdichten des versteiften porösen Kohlenstofffaservorformlings, sodass der isotrope Kohlenstoff innerhalb des versteiften porösen Kohlenstofffaservorformlings mit einem graphitierbaren Kohlenstoff eingekapselt wird, um die Kohlenstoff-Kohlenstoff-Verbundwerkstoffkomponente zu bilden.

2. Verfahren nach Anspruch 1, wobei das isotrope Harz Phenolharz oder Furanharz umfasst.

3. Verfahren nach Anspruch 1 oder 2, wobei das Verdichten des versteiften porösen Vorformlings, sodass der isotrope Kohlenstoff innerhalb des versteiften porösen Vorformlings mit dem graphitierbaren Kohlenstoff eingekapselt wird, umfasst:
Anwenden mindestens eines CVI/CVD-Zyklus auf den versteiften porösen Vorformling einschließlich des isotropen Kohlenstoffs, um den isotropen Kohlenstoff mit dem graphitierbaren Kohlenstoff einzukapseln.

4. Verfahren nach einem der Ansprüche 1 bis 3, wobei graphitierbarer Kohlenstoff rauen laminaren Kohlenstoff umfasst.

5. Verfahren nach einem der Ansprüche 1 bis 4, wobei der grapfitierbare Kohlenstoff die äußerste Schicht aus Kohlenstoffmaterial in der Kohlenstoff-Kohlenstoff-Verbundwerkstoffkomponente bildet.

6. Verfahren nach einem der Ansprüche 1 bis 5, ferner umfassend das Wärmebehandeln des isotropen Kohlenstoffs vor dem Einkapseln des isotropen Kohlenstoffs mit dem graphitierbaren Kohlenstoff.

7. Verfahren nach einem der Ansprüche 1 bis 6, wobei eine Dichte des versteiften porösen Vorformlings vorder Infusion des isotropen Harzes zwischen 0,8 g/cm³ und 1,7 g/cm³ liegt.

8. Verfahren nach einem der Ansprüche 1 bis 6, wobei eine Dichte der Kohlenstoff-Kohlenstoff-Verbundwerkstoffkomponente zwischen 1,72 g/cm³ und 1,87 g/cm³ liegt.

9. Verfahren nach einem der Ansprüche 1 bis 6, wobei die Dichte des infundierten und pyrolisierten Vorformlings zwischen 1,3 g/cm³ und 1,85 g/cm³ liegt.

10. Kohlenstoff-Kohlenstoff-Verbundwerkstoffkomponente, umfassend:
einen versteiften, porösen Kohlenstofffaservorformling, umfassend eine Vielzahl von kohlenstoffbeschichteten Fasern, die eine Vielzahl von Poren zwischen den kohlenstoffbeschichteten Fasern definieren;
Kohlenstoff innerhalb der Vielzahl von Poren und auf den kohlenstoffbeschichteten Fasern, wobei der Kohlenstoff innerhalb der Vielzahl von Poren mindestens 80 % isotropen Kohlenstoff einschließt; und
einen graphitierbaren Kohlenstoff auf dem isotropen Kohlenstoff, wobei der graphitierbare Kohlenstoff den isotropen Kohlenstoff einkapselt.

11. Kohlenstoff-Kohlenstoff-Verbundwerkstoffkomponente nach Anspruch 10, wobei graphitierbarer Kohlenstoff rauen laminaren Kohlenstoff umfasst.

12. Kohlenstoff-Kohlenstoff-Verbundwerkstoffkomponente nach einem der Ansprüche 10 oder 11, wobei eine Dichte der Kohlenstoff-Kohlenstoff-Verbundwerkstoffkomponente zwischen 1,72 g/cm³ und 1,87 g/cm³ liegt.

## Revendications

1. Procédé de formation d'un composant composite carbone-carbone, ledit procédé comprenant :
le dépôt d'une matière de carbone initiale dans une préforme en fibre de carbone poreuse à l'aide d'un dépôt chimique en phase vapeur (CVD, chemical vapor deposition) ou d'une infiltration chimique en phase vapeur (CVI, chemical vapor infiltration) pour former une préforme en fibre de carbone poreuse rigidifiée ;
l'infusion de la préforme en fibre de carbone poreuse rigidifiée avec une résine isotrope ;
la pyrolyse de la résine isotrope infusée pour former du carbone dans les pores de la préforme en fibre de carbone poreuse rigidifiée de telle sorte que le carbone formé dans les pores comprend au moins 80 % de carbone isotrope ; et
après l'infusion et la pyrolyse, l'épaississement de la préforme en fibre de carbone poreuse rigidifiée de telle sorte que le carbone isotrope à l'intérieur de la préforme en fibre de carbone poreuse rigidifiée est encapsulé avec un carbone pouvant subir une graphitisation pour former le composant composite carbone-carbone.

2. Procédé selon la revendication 1, dans lequel la résine isotrope comprend une résine phénolique ou une résine furannique.

3. Procédé selon la revendication 1 ou 2, dans lequel l'épaississement de la préforme poreuse rigidifiée de telle sorte que le carbone isotrope à l'intérieur de la préforme poreuse rigidifiée est encapsulé avec le carbone pouvant subir une graphitisation, comprend :
l'application d'au moins un cycle CVI/CVD à la préforme poreuse rigidifiée comprenant le carbone isotrope pour encapsuler le carbone isotrope avec le carbone pouvant subir une graphitisation.

4. Procédé selon l'une quelconque des revendications 1 à 3, dans lequel le carbone pouvant subir une graphitisation comprend du carbone laminaire rugueux.

5. Procédé selon l'une quelconque des revendications 1 à 4, dans lequel le carbone pouvant subir une graphitisation forme la couche la plus externe de la matière de carbone dans le composant composite carbone-carbone.

6. Procédé selon l'une quelconque des revendications 1 à 5, comprenant en outre le traitement thermique du carbone isotrope avant l'encapsulation du carbone isotrope avec le carbone pouvant subir une graphitisation.

7. Procédé selon l'une quelconque des revendications 1 à 6, dans lequel une densité de la préforme poreuse rigidifiée avant l'infusion de la résine isotrope est dans la plage comprise entre 0,8 g/cm³ et 1,7 g/cm³.

8. Procédé selon l'une quelconque des revendications 1 à 6, dans lequel une densité du composant composite carbone-carbone est dans la plage comprise entre 1,72 g/cm³ et 1,87 g/cm³.

9. Procédé selon l'une quelconque des revendications 1 à 6, dans lequel la densité de la préforme infusée et pyrolisée est dans la plage comprise entre 1,3 g/cm³ et 1,85 g/cm³.

10. Composant composite carbone-carbone comprenant :
une préforme en fibre de carbone poreuse et rigidifiée comprenant une pluralité de fibres revêtues de carbone, lesquelles définissent une pluralité de pores entre les fibres revêtues de carbone ;
du carbone dans la pluralité de pores et sur les fibres revêtues de carbone, le carbone dans la pluralité de pores comprenant au moins 80 % de carbone isotrope ; et
un carbone pouvant subir une graphitisation sur le carbone isotrope, dans lequel le carbone pouvant subir une graphitisation encapsule le carbone isotrope.

11. Composant composite carbone-carbone selon la revendication 10, dans lequel le carbone pouvant subir une graphitisation comprend du carbone laminaire rugueux.

12. Composant composite carbone-carbone selon l'une quelconque des revendications 10 ou 11, dans lequel une densité du composant composite carbone-carbone est dans la plage comprise entre 1,72 g/cm³ et 1,87 g/cm³.
